# EUROPEAN PATENT APPLICATION

(11) **EP 4 435 456 A1**
(43) Date of publication of application: **25.09.2024**
(21) Application number: 23163936.0
(22) Date of filing: 24.03.2023
(51) Int. Cl.: G01R 33/34, G01R 33/36, G01R 33/3415

(54) **RADIO FREQUENCY COIL SYSTEM FOR A MAGNETIC RESONANCE IMAGING APPARATUS**

(71) Applicant: Koninklijke Philips N.V., 5656 AG Eindhoven (NL)
(72) Inventor: WEISS, Steffen, Eindhoven (NL); LEUSSLER, Christoph Günther, Eindhoven (NL); LIPS, Oliver, 5656AG Eindhoven (NL)
(74) Representative: Philips Intellectual Property & Standards

(57) **Abstract**

According to the invention, a radio frequency coil system (1) for a magnetic resonance imaging system (38) is provided, comprising a main coil element (2) and a multitude of secondary coil elements (3), wherein the main coil element (2) and the secondary coil elements (3) are adapted for receiving radio frequency signals, the main coil element (2) and the secondary coil elements (3) each comprise connectors (4) which are adapted for connecting the secondary coil elements (3) to the main coil element (2) and/or to each other, respectively, such that a radio frequency signal received by a respective secondary coil element (3) is transmitted to the main coil element (2) directly or via one or more secondary coil elements (3) respectively, and the main coil element (2) comprises a data interface which is adapted for making a data connection to the magnetic resonance imaging system (38) for transmitting the radio frequency signals which have been received from the secondary coil elements (3) to the magnetic resonance imaging system (38). In this way, a radio frequency coil system with improved signal transmission is provided.

## Description

### FIELD OF THE INVENTION

The invention relates to the field of magnetic resonance imaging. In particular, the present invention relates to the field of a radio frequency coil system or a magnetic resonance imaging apparatus.

### BACKGROUND OF THE INVENTION

A part of every magnetic resonance imaging device is the radio frequency coil for receiving a magnetic resonance signal that is a radio frequency signal. The radio frequency coil comprises a fixed array of radio frequency coil elements arranged to cover the surface of the patient. The radio frequency signal of each coil element is amplified and digitized separately employing a downstream preamplifier and an analog-to-digital converter. The radio frequency coil, the preamplifier and the analog to digital converter form a radio frequency antenna system. In magnetic resonance imaging the system integrated body coil generates the excitation magnetic field for the spin system causing a preceding relaxation. The precession of the net magnetization induces a current in the radio frequency coil via electromagnetic induction. The radio frequency coil comprises generally a conducting wire with an inductance and a coil resistance. Like any radio frequency operated system, the radio frequency antenna system is subject to noise. Thereby, the most important requirement is to achieve a minimum noise figure. The lowest noise figure is achieved if the source impedance is matched to the noise impedance of the preamplifier. The signal-to-noise ratio depends on the patient geometry, the size of the bore and the relative position of the radio frequency coil within the bore. This means that the signal-to-noise ratio cannot be maintained at a constant level, as it depends on the patient, the radio frequency coil to be used and the position of the coil on the patient.

Since the signal-to-noise ratio depends on the distance between the radio frequency coil and the patient, it is important to adapt the radio frequency coil as conformally as possible to the body. Particularly in the case of larger coils that are to cover a larger body surface, this is challenging due to the unevenness of the patient's body. Therefore, magnetic resonance imaging sites are commonly equipped with a collection of different radio frequency coils with different sizes and shapes. Most radio frequency coils have a large number of fixed coil elements (8 to 16) and are relatively bulky. There may be a variety of different coils with 4, 6, 8, 12, 16 fixed coil elements all present in one magnetic resonance imaging site, each used for differently sized patients and different body parts.

Neighbored coil elements couple with each other mainly inductively. If each coil element has previously been separately tuned to the magnetic resonance frequency and matched to the input impedance of the preamplifier, the mutual coupling between the elements generates coupled modes, which cause splitting in the coils' spectra. Consequently, the radio frequency coils become detuned and mismatched again, causing a reduction in the signal-to-noise ratio. Additionally, their sensitivity profiles become overlapping, causing image artefacts and less scan time reduction in parallel imaging. To maintain the signal-to-noise ratio of the elements and optimal use of parallel imaging, the coil elements need to be decoupled again.

Standard decoupling for fixed coil elements is done by connecting the coil outputs by suitable reactive networks. The layout and dimensioning of these networks depends on the mutual inductive coupling between the coil elements, which is mainly determined by their relative spatial arrangement. The relative spatial arrangement of individual coil elements is largely fixed in a state-of-the-art radio frequency coil. Therefore, fixed decoupling networks can be used.

The variety of conventional radio frequency coils take up a lot of space in relation to the magnetic resonance imaging device. They are not easy to use and if only one element fails, the entire radio frequency coil must be replaced, so that the body part in question can no longer be examined with the corresponding radio frequency coil due to the failure of a single radio frequency coil element. Furthermore, even with dedicated radio frequency coils for individual body regions, the distances between the radio frequency coil and the patient surface become so wide that they reduce the signal-to-noise ratio only due to the differences between the patients.

The publication 'A Flexible and Modular Receiver Coil Array for Magnetic Resonance Imaging' by Tasso Yeh JN, Lotus Lin JF, Li YT and Lin FH in IEEE Transactions on Medical Imaging, 38(3), 824-833, 2019; describes a system of a radio frequency coil that is based on several wired four-element-coils that can be placed close to each other on a regular grid, so that the defined distance and element overlap provides decoupling. Each four-element-coil is wired itself and sets of two four-element-coils have always to be used together. Modular expandable radio frequency coils often have the disadvantage that each radio frequency coil element must be wired individually and that at least two coil elements must be used, so that the increased likelihood of interference and the susceptibility to faults in these modular systems represent a disadvantage.

### SUMMARY OF THE INVENTION

It is an object of the invention to provide a radio frequency coil with improved signal transmission.

According to the invention, this object is addressed by the subject matter of the independent claims. Preferred embodiments of the invention are described in the sub claims.

Therefore, according to the invention a radio frequency coil system for a magnetic resonance imaging system is provided, comprising a main coil element and a multitude of secondary coil elements, wherein the main coil element and the secondary coil elements are adapted for receiving radio frequency signals, the main coil element and the secondary coil elements each comprise connectors which are adapted for connecting the secondary coil elements to the main coil element and/or to each other, respectively, such that a radio frequency signal received by a respective secondary coil element is transmitted to the main coil element directly or via one or more secondary coil elements respectively, and the main coil element comprises a data interface which is adapted for making a data connection to the magnetic resonance imaging system for transmitting the radio frequency signals which have been received from the secondary coil elements to the magnetic resonance imaging system.

The main coil element has a data interface that is designed to transmit the radio frequency signal to the magnetic resonance imaging system. The secondary coil elements, on the other hand, are connected to each other and/or to the main coil element in such a way that the radio frequency signal received by the respective secondary coil element or the main coil element can be transmitted to the magnetic resonance imaging system via the data interface. This makes it possible, for example, in the case of a wired connection between the main coil element and the magnetic resonance imaging system, for only the main coil element to be connected to the magnetic resonance imaging system. The secondary coil elements do not have to be connected in this way, which makes it much easier to handle the radio frequency coil system, reduces possible faults and allows more freedom in positioning the radio frequency coil system. Thereby the radio frequency signal to be transmitted to the magnetic resonance imaging system can be transmitted either by cable or wirelessly to the magnetic resonance imaging system by employing the data interface.

The modular design of the radio frequency coil system has the particular advantage that the radio frequency system formed with the main coil element and the secondary coil elements is suitable for any imaging entity. For example, an abdominal image acquisition can be performed with a radio frequency coil system covering the upper part of a patient's body. Likewise, with the same system and, compared to the abdominal image acquisition, fewer secondary coil elements, an ankle or shoulder can be examined without the need for a dedicated shoulder or joint radio frequency coil. Especially with respect to smaller magnetic resonance imaging sites, they are able to perform different imaging with the radio frequency coil system according to the invention and do not have to have a dedicated space-consuming radio frequency coil for each imaging entity, which also represents a considerable cost factor.

At the same time, a high degree of conformity is achieved with regard to the attachment of the radio frequency coil system on a patient. Here, the term "attached to a patient" means that the radio frequency coil is located with respect to the patient in a bore of the magnetic resonance imaging device. Advantageously, the radio frequency coil may be placed on the patient's body surface to reduce signal transmission through air. This results in a higher signal-to-noise ratio due to the short distance between the radio frequency coil system of the invention and the patient surface.

Another advantage of the radio frequency coil system according to the invention is that it is basically still functional in the event of a defect in a secondary coil element or even a main coil element. The defective element must be replaced and repaired, but the functionality of the other elements is still given, so that it is not necessary to have entire radio frequency coils, such as a head coil, in stock in duplicate. Rather, only individual coil elements need to be available as replacements.

In addition, the daily clinical routine with the system according to the invention is significantly simplified, particularly with regard to the cleaning effort and the ability to automate the cleaning of the coil elements.

Preferably, the main coil element and the secondary coil elements are formed in such a way and are equipped with the connectors in such a way that a plurality of secondary coil elements can directly be connected to the main coil element. The main coil element and the secondary coil elements may each comprise a single coil or multiple coils for receiving radio frequency signals. Likewise, several main coil elements can be permanently connected next to each other, in which case each of these main coil elements can be connected to a number of secondary coil elements.

In principle, the secondary coil elements can be designed in different ways. However, according to a preferred embodiment of the invention, the secondary coil elements comprise at least a first group of secondary coil elements which all are identical. In this case, it is preferred that the secondary coil elements have the same size and shape. In this respect, preferably, the main coil element has also the same shape and size as the secondary coil elements. This allows the secondary coil elements to be connected to each other in a homogeneous grid, so that one secondary coil element is equally spaced to another secondary coil element.

According to a preferred embodiment of the invention the secondary coil elements comprise a second group of secondary coil elements which all are identical and have such a size and shape that a single secondary coil element of the second group may replace multiple single secondary coil elements of the first group. This means that the secondary coil elements of the first group are smaller in size than the secondary elements of the second group and that instead of using multiple secondary coil elements of the first group, one single coil element of the second group may be used. Hence, a single coil element of the second group covers essentially the same area as a combination of multiple secondary coil elements of the first group which are connected to each other. However, the covered area may not be 100 % identical due to rounded corners or the like. For example, if the connection of the secondary coil elements of the first and second group is considered to be a grid with basic grid elements with a certain area, a secondary coil element of the first group could cover a single grid element while a secondary coil element of the second group could cover two grid elements.

In principle, the main coil element and the second coil elements can have different shapes. Preferably, however, the main coil element and the secondary coil elements are quadrangular. More preferably, the main coil element and the secondary coil elements are square or rhombic. Due to the fact that all four sides or borders of a square or a rhombus have the same length, the secondary coil elements can be connected to each other or to the main coil element on all four sides which allows for forming a homogeneous grid with the main coil element and the connected secondary coil elements around the main coil element. Several square main coil elements could be attached together, for example, four main coil elements can be connected to each other arranged in a square, so that each main coil element has three borders at which secondary coil elements can be connected.

It is possible to design the connectors in different ways. According to a preferred embodiment of the invention, however, the connectors are coaxial contacts with an inner conductor and an outer conductor, wherein the inner conductor is adapted for transmitting a received radio frequency signal and the outer conductor forms a shielding of the inner conductor. In particular, the connectors are constructed in the type of a coaxial cable. The outer conductor shields the inner conductor, which transmits the received radio frequency signal, from electromagnetic interference. This allows reducing the influence of electromagnetic interference on the received radio frequency signal.

According to an especially preferred embodiment of the invention, the outer conductor is also adapted for mechanically fixing one connector to another connector. The principle of a snap fastener is preferably employed here. In this respect there are preferably two different types of connectors which are designed as a connector head and as a connector recess, respectively, wherein the connector head is formed in such a way that it is connectable to the connector recess, the inner conductor is arranged in the center of the connector head and in the center of the connector recess, the outer conductor surrounds the inner conductor in a ring-like manner, such that the outer conductor of the connector head and the outer conductor of the connector recess contact one another and shield the contacting inner conductors when the connector head and connector recess are connected to each other. The connector head is then arranged accordingly on a top or bottom side of the coil element. The connector recess is then correspondingly arranged on the respective bottom or top side of the further coil element, so that the coil elements can be contacted with each other without having to flip a coil element. These connectors are provided in a fixed position relative to an edge of the respective coil element so that the coil elements are equally spaced apart. In contrast to rotation, which describes a rotation around a normal vector perpendicular to the surface of the coil, flipping of the coil element means a rotation perpendicular to the normal vector which is perpendicular to the surface of the coil element. When coil elements are mentioned here, both secondary coil elements and the main coil element are meant.

In principle, the connectors can be arranged in various ways on the secondary coil element. According to a preferred embodiment of the invention, however, each secondary coil element is provided with first connectors on a first border, the first connectors being arranged along a straight line and equidistantly from each other, each secondary coil element is provided with second connectors on a second border, the second border being opposite to the first border and the second connectors being arranged along a straight line and equidistantly from each other at the same distance as the first connectors, and multiple feedthrough lines are provided, wherein each feedthrough lines is arranged between one of the first connectors and one of the second connectors, respectively for transmitting a received radio frequency signal between the respective first connector and the respective second connector, wherein each feedthrough line connects a first connector with such a second connector which is offset by one place relative to the first connector along the straight line.

Thereby, the radio frequency signal received with a secondary coil element can be transmitted to the main coil element with the respective feedthrough lines. The number of connectors on one border of the main coil element thus determines the maximum number of secondary coil elements that can be connected to that border of the main coil element, since each radio frequency signal received by a secondary coil element is transmitted to the main coil element via a respective feedthrough line.

In principle, it can be provided that the radio frequency signal received with the secondary coil element is receivable at different connectors. According to a preferred embodiment of the invention, however, the first connectors or the second connectors comprise an initial connector which is not attached to a feedthrough line which is arranged between a first connector and a second connector, but which is attached to a transmission line which is adapted for supplying a radio frequency signal received by the respective secondary coil element to the initial connector.

Preferably, the number of the first connectors and the number of second connectors differs by the number of one. The border of the secondary coil element facing the main coil element is the border of the secondary coil element that has one more connector than the opposite border. In this way, the radio frequency signal of the initial connector of the respective secondary coil element is always picked up in further connected secondary coil elements and transmitted to the main coil element in a corresponding feedthrough line.

In addition, these secondary coil elements can be provided with feedthrough lines that are offset from the feedthrough lines connecting the first and second borders. Secondary coil elements, which are quadrangular, generally have a third border and a fourth border, whereby the third border and the fourth border are also provided third connectors arranged in a straight line equidistantly from each other and fourth connectors arranged in a straight line equidistantly from each other, which are connected analogously to the first connectors and the second connectors via feedthrough lines in such a way that each radio frequency signal received by a secondary coil element can be transmitted to the main coil element via a respective feedthrough line. The third connectors and the fourth connectors comprise an initial connector which is not connected to a feedthrough line arranged between a third connector and a fourth connector, but which is connected to a transmission line adapted to deliver a radio frequency signal received from the respective secondary coil element to the initial connector. In the case of square secondary coil elements, said third connectors arranged at the third border, said fourth connectors arranged at the fourth border, and said feedthrough lines connecting said third connectors and said fourth connectors are rotated by 90° with respect to said first connectors arranged at the first border, said second connectors arranged at the second border, and said feedthrough lines connecting said first connectors and said second connectors. This enables further secondary coil elements to be connected to the third border and the fourth border of the secondary coil element.

Alternatively, it is also possible that the third border and the fourth border each have third connectors and fourth connectors that are connected to the first connectors of the first border by means of feedthrough lines in a manner analogous to the second connectors of the second border, so that the second connectors of the second border, the third connectors of the third border, and the fourth connectors of the fourth border route radio frequency signals with respective feedthrough lines to the first connectors of the first border. Thus, on the one hand, there can be secondary coil elements that can forward incoming radio frequency signals from two borders to two borders accordingly. On the other hand, there can be secondary coil elements that can forward radio frequency signals from three borders to one border.

Radio frequency signal transmission of secondary coil elements of the second group of secondary coil elements is performed such that it leaves one connector unused for signal transmission, such that the correct order of radio frequency signal feedthrough lines is maintained. This design ensures that the radio frequency signals of secondary coil elements of the second group are channeled to corresponding connectors of secondary coil elements of the first group.

To ensure that the received radio frequency signal is transmitted with as little noise as possible, appropriate radio frequency trapping can also be used to filter out the common mode currents generated in the high-frequency transmission lines by the magnetic resonance imaging system. Long radio frequency transmission lines inside or close to the magnetic resonance imaging devices opening, the bore, need to be equipped with means to suppress radio frequency induced common mode currents, since otherwise image artifacts or even patient burns could occur. Especially if the length of the radio frequency transmission line comes close to being resonant, significant radio frequency power can be picked up. Preferably, this radio frequency trapping can be achieved by providing at least the feedthrough lines of a part of the secondary coil elements each with a tank circuit by forming an inductance and connecting a capacitor in parallel to the respective feedthrough line.

In the alternative, it is preferred that at least the feedthrough lines of a part of the secondary coil elements are each provided with a floating cable trap which is arranged the respective feedthrough lines for coupling inductively with them. The floating type of cable trap does not require physical connection to the feedthrough lines. A floating cable trap can consist of two coaxial concentric conductive cylinders, where one end is shorted together and the other end is tuned to resonance.

Basically, the preamplifier does not have to be included in the radio frequency coil system. The preamplifier can also be included in the magnetic resonance imaging system and receive the radio frequency signal output from the main coil element. According to a preferred embodiment of the invention, however, each secondary coil element is equipped with a preamplifier for preamplifying a radio frequency signal before transmitting it to another secondary coil element or to the main coil element. This can prevent costly noise matching. The impedance of the respective feedthrough line has no influence on the received radio frequency signal to be amplified, since it can already be amplified immediately after being received in the respective secondary coil element with the respective preamplifier.

According to a preferred embodiment of the invention, the main coil element is equipped with preamplifiers, each preamplifier being assigned to one single secondary coil element, respectively, for preamplifying a radio frequency signal received from a respective secondary coil element. For this purpose, it can be provided that preamplifiers are designed in the form of a preamplifier array in a modular scalable array or that a preamplifier has several channels with which the preamplifier array in a modular scalable array can be realized. The preamplifier array is then located in a connector which is connected to the main coil element and has a number of channels corresponding to the maximum number of coil elements so that, depending on the secondary coil elements connected to the main coil element, a preamplifier channel is available for radio frequency signal preamplification for the respective received radio frequency signal.

According to a further preferred embodiment of the invention, each preamplifier comprises a matching circuit or each secondary coil element is equipped with a matching circuit for noise matching the respective preamplifier. When all preamplifiers are contained in the main coil element, the conductor impedance of each secondary coil element changes depending on the number of chained secondary coil elements due to the varying length of the feedthrough lines. Therefore, each preamplifier is preferably noise matched per secondary coil element configuration. Preferably, the matching circuit has at least two modes which can be switched with Gallium Nitride switches (GaN). According to this embodiment of the invention, all preamplifiers are contained in the main coil element, and non-amplified radio frequency signals are routed through the secondary coil elements to the main coil element.

In principle, a controller can be formed in the magnetic resonance imaging system in various ways. According to a preferred embodiment of the invention, however, the radio frequency coil system further comprises a controller, wherein the controller is adapted for identifying the secondary coil elements connected to the respective main coil element, and for thereby adjusting the matching circuits. When an additional secondary coil element is connected to the main coil element or a further secondary coil element, this new connection is automatically established. The new connection also triggers automatic radio frequency decoupling of the new element from all neighbored secondary elements and/or the main coil element. This is possible because decoupling electronics implemented in the controller can be pre-tuned by making use of the known relative geometry, the distance between the respective coil elements and their known size. The identification of additional coil elements and correct allocation of coil impedance to the preamplifier can be performed by different methods like optical or galvanical signaling or digital keying. The identification of the impedance and the feedthrough line length can be realized by short voltage pulse detection performed prior to imaging.

Further, according to the invention, a magnetic resonance imaging apparatus with a radio frequency coil system according to any one of the preceding claims is provided.

The invention further relates to a method of operating a radio frequency coil system for a magnetic resonance imaging system which comprises a main coil element and a multitude of secondary coil elements which are connected to the main coil element or to each other, respectively, the method comprising the following method steps: receiving radio frequency signals with at least the secondary coil elements, transmitting a radio frequency signal received by a respective secondary coil element to the main coil element directly or via one or more secondary coil elements respectively, making a data connection from the main coil element to the magnetic resonance imaging system, and transmitting the radio frequency signals which have been received from the secondary coil elements to the magnetic resonance imaging system via the data connection. This connection can be wired or wireless.

According to a preferred embodiment of the invention, the method further comprises the following steps: identifying the secondary coil elements connected to the respective main coil element, and controlling at least one matching circuit for adjusting an impedance value of the radio frequency coil system. Each secondary coil element is identified and its relative position compared to other secondary coil elements is also identified.

Further, according to the invention, a computer-readable medium comprising instructions thereon which, when executed by a radio frequency coil system for a magnetic resonance imaging system, cause the frequency coil system to carry out the method of any one of claims (first method claim to last method claim).

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts a radio frequency coil system according to a preferred embodiment of the invention;
Fig. 2 schematically depicts a connector according to a preferred embodiment of the invention;
Fig. 3a schematically depicts a first radio frequency trap according to a preferred embodiment of the invention;
Fig. 3b schematically depicts a second radio frequency trap according to a preferred embodiment of the invention;
Fig. 3c schematically depicts a third radio frequency trap according to a preferred embodiment of the invention;
Fig. 4 schematically depicts another radio frequency coil system according to a preferred embodiment of the invention;
Fig. 5 schematically depicts a secondary coil element according to a preferred embodiment of the invention;
Fig. 6 schematically depicts a scheme of a method according to a preferred embodiment of the invention; and
Fig. 7 schematically depicts a magnetic resonance imaging system according to a preferred embodiment of the invention.

### DETAILED DESCRIPTION OF EMBODIMENTS

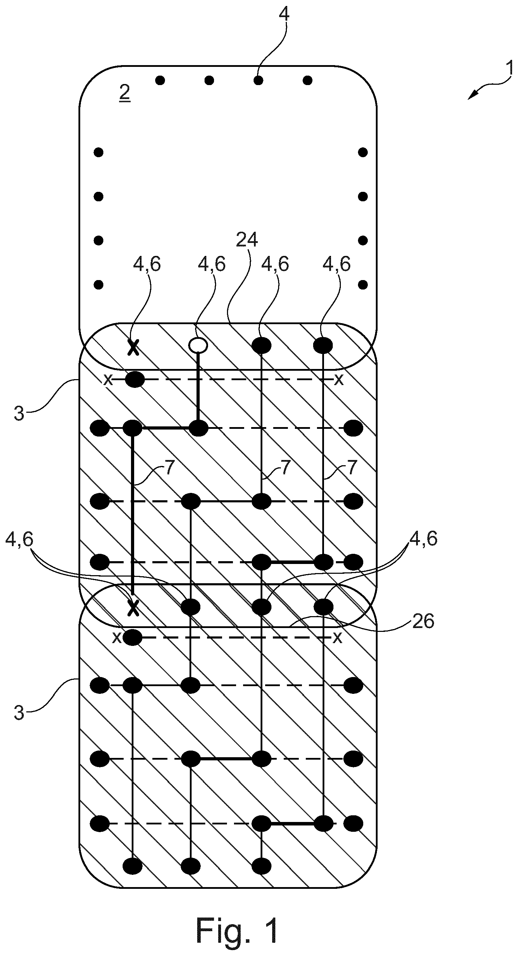

Fig. 1 depicts schematically a radio frequency coil system 1 according to a preferred embodiment of the invention. The radio frequency coil system 1 in Fig. 1 according to the invention has a main coil element 2 and a secondary coil element 3 connected to the main coil element 2. The secondary coil element 3 connected to the main coil element 2 is in turn connected to a further secondary coil element 3. The main coil element 2 is square-shaped with rounded corners. Along each border of the main coil element 2, four connectors 4 are formed in a straight line equidistant from each other. Analogous to the main coil element 2, the square secondary coil element 3 also has four connectors 4 each, which are formed along each border of the secondary coil element in a straight line equidistant from each other, analogous to the connectors 4 of the main coil element.

A first border 24 of the secondary coil element 2 is provided with four first connectors 6, which are connected to the main coil element 2 in such a way that radio frequency signals can be transmitted. One of the first connectors 6 is designed as an initial connector 6, which is connected to further initial connectors 6 of the secondary coil element 3 in such a way that a transmission line is formed, which is suitable for feeding a radio frequency signal received from the respective secondary coil element 3 to the initial connector 6. The initial connectors 6 are marked with an 'x' in Fig. 1.

The further first connectors 6 of the first border 24 are connected to second connectors 6 of a second border 26 by means of feedthrough lines 7 in such a way that a radio frequency signal can be transmitted from the second connectors 6 to the first connectors 6. The second border 26 is located opposite the first border 24. A radio frequency signal received with the further secondary coil element 3 is transmitted to the second connector 6 of the second border 26 of the secondary coil element 3 via an initial connector 6 on the first border 24 of the further secondary coil element 3, which is also marked with an 'x' in the further secondary coil element 3. The radio frequency signal is then transmitted accordingly with the feedthrough line 7 formed between the first connector 6 of the first border 24 of the further secondary coil element 3 and the second connector 6 of the second border 26 towards the first connector 6 of the first border 24, so that the radio frequency signal can be transmitted to the main coil element 2. The second connector 6 from which the radio frequency signal is transmitted is offset by one place relative to the first connector 6 along a straight line between the first and second connectors 6. The here referred straight line runs perpendicular to the straight line along which the first connectors are arranged.

Finally, the two further first connectors 6 of the first border 24 of the secondary coil element 3 are connected to the second connectors 6 by means of two further feedthrough lines 7, the second connectors 6 also being offset by one place relative to the first connector 6 along the straight line between the first and second connectors 6. Due to this continuous offset and the thereby formed cascading connection in the feedthrough lines 7, which is also continued in the further secondary coil element 3, it is possible in the specific case of four connectors on one border of the main coil element 2 that up to four secondary coil elements 3 are connected in series and that the radio frequency signal received with the respective secondary coil element 3 can be transmitted through the corresponding feedthrough line 7 to the main coil element 2.

Each of the secondary coil elements 2 shown in Fig. 1 also has a third and a fourth border. The third border is analogous to the first border 24, the fourth border analogous to the second border 26. Feedthrough lines 7 are also formed between the third and fourth borders, which connect the corresponding connectors analogously to the diagram between the first border 24 and the second border 26 for the purpose of radio frequency signal transmission.

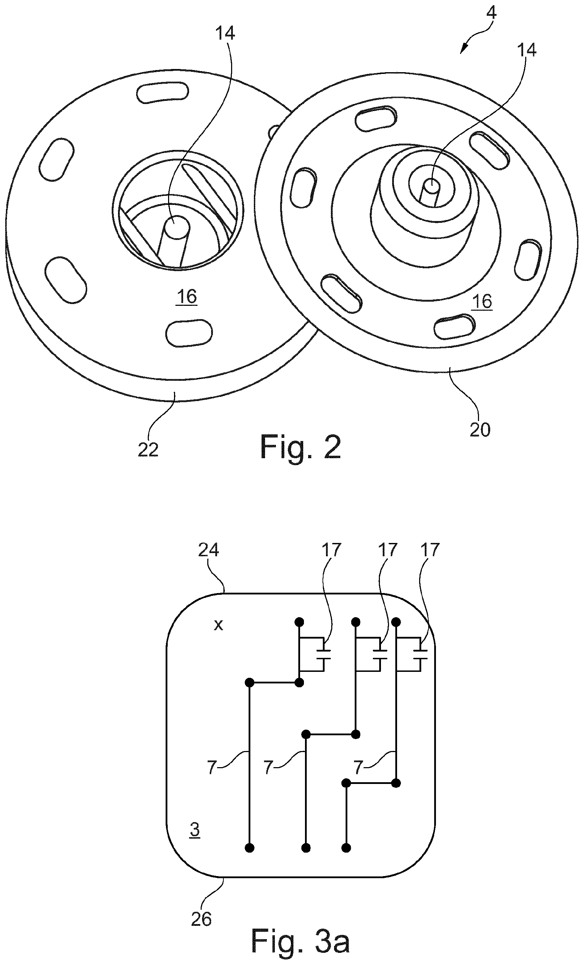

Fig. 2 schematically depicts a connector according to a preferred embodiment of the invention. This connector 4 is designed according to the model of a snap fastener. An inner conductor 14 is formed in a center of the connector head 20 and in a center of the connector recess 22. The inner conductor 14 is configured to transmit the radio frequency signal. An outer conductor 16 is isolated from the inner conductor 16 and surrounds it in an annular manner. The outer conductor 16 shields the inner conductor 14 so that the radio frequency signal has less electromagnetic interference. The connector head 20 formed by the outer conductor 16 can be mechanically connected to the connector recess 22 in the manner of a snap fastener by applying mechanical pressure to the correspondingly brought together connectors 4. Thus, the inner conductors 14 contact each other in such a way that the radio frequency signal can be transmitted. The outer conductors 16 shield the radio frequency signal from external electromagnetic interferences. The connectors 4 are accordingly coaxial.

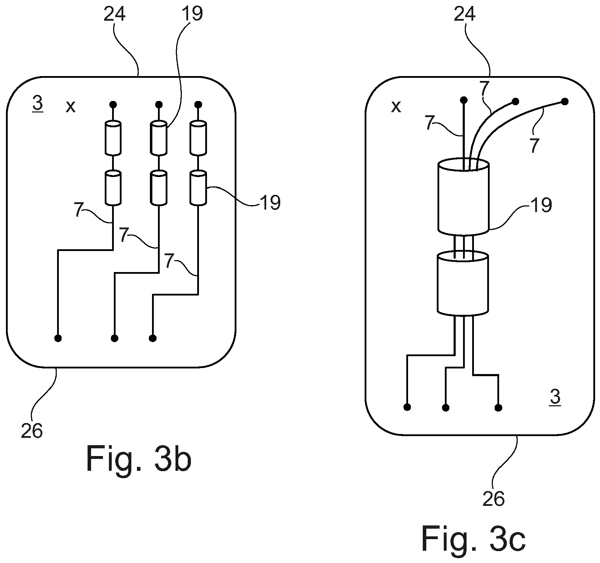

Fig. 3a schematically depicts a first radio frequency trap according to a preferred embodiment of the invention. For this purpose, the feedthrough lines 7 of the secondary coil element 3 are provided with capacitors 17, which are designed parallel to the respective feedthrough line. In addition, the corresponding feedthrough line 7 can be looped to form an inductance. Specifically, however, the inductance of the coaxial connectors 4 is used together with the corresponding capacitor 17 of the respective feedthrough line 7 to form a tank trap with which common mode currents can be trapped in the feedthrough lines 7. Fig. 3b schematically shows another radio frequency trap. Common mode currents are trapped here by two successive hollow cylinders inductively coupled to the respective feedthrough line 7, arranged coaxially to the respective feedthrough line 7 but galvanically separated from it. This arrangement for each feedthrough line 7 forms a floating cable trap 19. Alternatively, in Fig. 3c, a single floating cable trap 19 can be formed with all feedthrough lines 7.

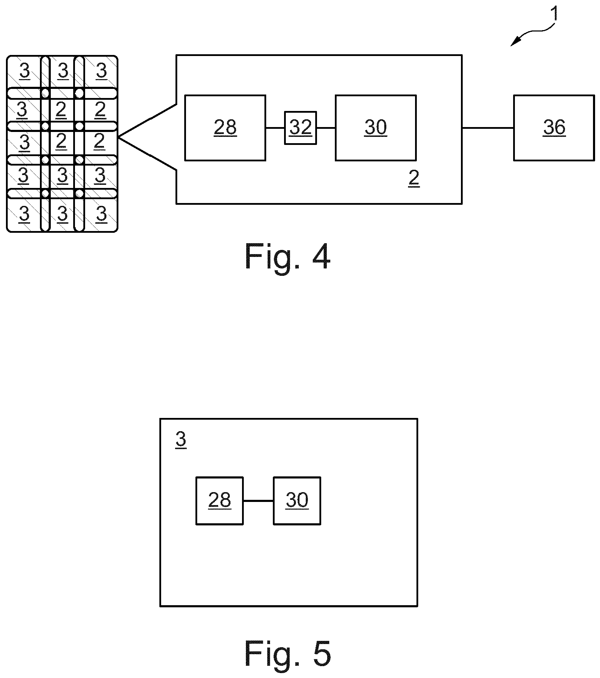

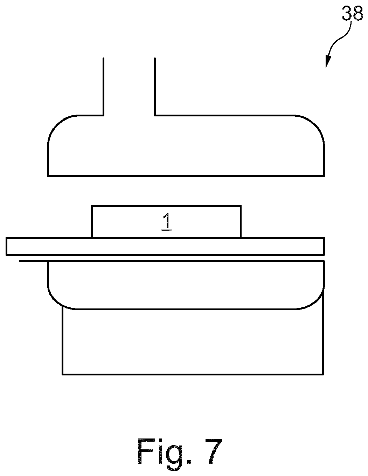

Fig. 4 schematically depicts a further radio frequency coil system 1 according to a preferred embodiment of the invention, comprising four main coil elements 2 that are connected to each other in such a way that the main coil elements 2 form a square. Each main coil element 2 is connected to further secondary coil elements 3, so that a radio frequency coil system 1 is formed, with which large-area magnetic resonance images can be acquired with a magnetic resonance imaging system, as shown in Fig. 7. Each main coil element 2 has a matching circuit 28, a preamplifier 30 and a modular scalable array 32. The preamplifier 30 is connected to the matching circuit 28 via the modular scalable array 32. The impedance of the radio frequency signal of each secondary coil element 3 is matched to the impedance of the preamplifier 30 by the matching cirquit 28, taking into account the impedance of the respective secondary coil element 3, the patient-specific impedance, and the impedance contained in the length of the feedthrough line 7. The preamplifier 30 is connected to a modular scalable array 32 in such a way that the impedance-matched radio frequency signal of each secondary coil element 3 and of the main coil element 2 can be amplified accordingly. The modular scalable array 32 has a maximum number of channels corresponding to that of the secondary coil elements 3 and the main coil element 2. With a controller 36 connected to the main coil element 2, the specific number of secondary coil elements 3 connected to one of the main coil elements 2 can be measured, so that the controller 36 can provide a corresponding number of preamplifier 30 channels in the modular scalable array 32 to the respective feedthrough lines 7 for preamplification.

It can also be provided that, as shown in Fig. 5, each secondary coil element 3 and/or the main coil element 2 contains a matching circuit 28 connected to a preamplifier 30, so that the radio frequency signal received by the respective coil element can be directly matched in impedance and amplified by the preamplifier 30.

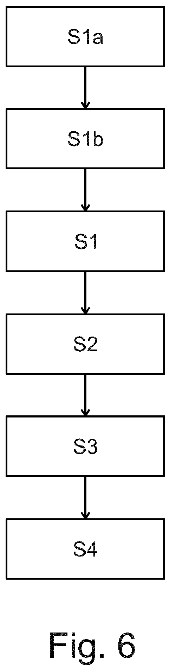

Fig. 6 schematically depicts a scheme of a method according to a preferred embodiment of the invention, wherein in a first step S1a the secondary coil elements 3 connected to the respective main coil element are identified. Second in a further step S1b the matching circuit 28 for adjusting an impedance value of the radio frequency coil system 1 is controlled. Third, in a step S1 radio frequency signals are received with the secondary coil elements 3 and the main coil element 2. Fourth, in a step S2 the radio frequency signals received with the respective secondary coil element 3 is transmitted directly or via one or more secondary coil elements 3 to the main coil element 2. In a further step S3 a data connection from the main coil element 2 to the magnetic resonance imaging system 38 is established such that the radio frequency signals which have been received from the secondary coil elements 3 can be transmitted to the magnetic resonance imaging system 38 in a step S4 via the data connection.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Radio frequency coil system | 1 |
| Main coil element | 2 |
| Secondary coil element | 3 |
| Connector | 4 |
| First connectors/ second connectors | 6 |
| Feedthrough line | 7 |
| Inner conductor | 14 |
| Outer conductor | 16 |
| Capacitor | 17 |
| Floating cable trap | 19 |
| Connector head | 20 |
| Connector recess | 22 |
| First border | 24 |
| Second border | 26 |
| Matching circuit | 28 |
| Preamplifier | 30 |
| Modular scalable array | 32 |
| Controller | 36 |
| Magnetic resonance imaging apparatus | 38 |

## Claims

1. Radio frequency coil system (1) for a magnetic resonance imaging system (38), comprising
a main coil element (2) and a multitude of secondary coil elements (3), wherein
the main coil element (2) and the secondary coil elements (3) are adapted for receiving radio frequency signals,
the main coil element (2) and the secondary coil elements (3) each comprise connectors (4) which are adapted for connecting the secondary coil elements (3) to the main coil element (2) and/or to each other, respectively, such that a radio frequency signal received by a respective secondary coil element (3) is transmitted to the main coil element (2) directly or via one or more secondary coil elements (3) respectively, and
the main coil element (2) comprises a data interface which is adapted for making a data connection to the magnetic resonance imaging system (38) for transmitting the radio frequency signals which have been received from the secondary coil elements (3) to the magnetic resonance imaging system (38).

2. Radio frequency coil (1) according to claim 1, wherein the secondary coil elements (3) comprise a first group of secondary coil elements (3) which all are identical.

3. Radio frequency coil system (1) according to claim 2, wherein the secondary coil elements comprise a second group of secondary coil elements which all are identical and have such a size and shape that a single secondary coil elements of the second group may replace multiple single secondary coil elements of the first group.

4. Radio frequency coil system (1) according to any one of the preceding claims, wherein the connectors (4) are coaxial contacts with an inner conductor (14) and an outer conductor (16), wherein the inner conductor (14) is adapted for transmitting a received radio frequency signal and the outer conductor (16) forms a shielding of the inner conductor (14).

5. Radio frequency coil system (1) according to claim 4, wherein the outer conductor (16) is also adapted for mechanically fixing one connector (4) to another connector (4).

6. Radio frequency coil system (1) according to any one of the preceding claims, wherein
each secondary coil element (3) is provided with first connectors (6) on a first border (24), the first connectors (6) being arranged along a straight line and equidistantly from each other,
each secondary coil element (3) is provided with second connectors (6) on a second border (24), the second border (26) being opposite to the first border (24) and the second connectors (6) being arranged along a straight line and equidistantly from each other at the same distance as the first connectors (6), and
multiple feedthrough lines (7) are provided, wherein each feedthrough lines (7) is arranged between one of the first connectors (6) and one of the second connectors (6), respectively for transmitting a received radio frequency signal between the respective first connector (6) and the respective second connector (7), wherein
each feedthrough line (7) connects a first connector (6) with such a second connector (6) which is offset by one place relative to the first connector along the straight line.

7. Radio frequency coil system (1) according to claim 6, wherein the first connectors (6) or the second connectors (6) comprise an initial connector (6) which is not attached to a feedthrough line (7) which is arranged between a first connector (6) and a second connector (6), but which is attached to a transmission line which is adapted for supplying a radio frequency signal received by the respective secondary coil element (3) to the initial connector (6).

8. Radio frequency coil system (1) according to any one of the preceding claims, wherein each secondary coil element (3) is equipped with a preamplifier (30) for preamplifying a radio frequency signal before transmitting it to another secondary coil element (3) or to the main coil element (2).

9. Radio frequency coil system (1) according to any one of the preceding claims, wherein the main coil element (2) is equipped with preamplifiers (30), each preamplifier (30) being assigned to one single secondary coil element (3), respectively, for preamplifying a radio frequency signal received from a respective secondary coil element (3).

10. Radio frequency coil system (1) according to claim 9, wherein each preamplifier (30) comprises a matching circuit (28) or each secondary coil element (3) is equipped with a matching circuit (28) for noise matching the respective preamplifier (30).

11. Radio frequency coil system (1) according to claim 10, further comprising a controller (36), wherein the controller (36) is adapted for identifying the secondary coil elements (3) connected to the respective main coil element (2), and for thereby adjusting the matching circuits (28).

12. Magnetic resonance imaging apparatus (38) with a radio frequency coil system (1) according to any one of the preceding claims.

13. Method of operating a radio frequency coil system (1) for a magnetic resonance imaging system (38) which comprises a main coil element (2) and a multitude of secondary coil elements (3) which are connected to the main coil element (2) or to each other, respectively, the method comprising the following method steps:
receiving radio frequency signals with at least the secondary coil elements (3),
transmitting a radio frequency signal received by a respective secondary coil element (3) to the main coil element (2) directly or via one or more secondary coil elements (3) respectively,
making a data connection from the main coil element (2) to the magnetic resonance imaging system (38), and
transmitting the radio frequency signals which have been received from the secondary coil elements (3) to the magnetic resonance imaging system (38) via the data connection.

14. Method according to claim 13, further comprising the following steps:
identifying the secondary coil elements (3) connected to the respective main coil element (2), and
controlling at least one matching circuit (28) for adjusting an impedance value of the radio frequency coil system (1).

15. A computer-readable medium comprising instructions thereon which, when executed by a radio frequency coil system (1) for a magnetic resonance imaging system (38), cause the frequency coil system (1) to carry out the method of any one of claims 13 or 14.
